# EUROPÄISCHE PATENTANMELDUNG

(11) **EP 0 527 373 A1**
(43) Veröffentlichungstag der Anmeldung: **17.02.1993**
(21) Anmeldenummer: 92112710.6
(22) Anmeldetag: 24.07.1992
(51) Int. Cl.: G01T 1/29, H01L 27/14

(54) **Detektorsystem**

(30) Priorität: 05.08.1991 DE 4125928
(71) Anmelder: SIEMENS AKTIENGESELLSCHAFT, D-80333 München (DE)
(72) Erfinder: Birkle, Siegfried, Dr., W-8552 Höchstadt/Aisch (DE); Kammermaier, Johann, Dr., Verstorben (DE); Rittmayer, Gerhard, Dr., W-8520 Erlangen (DE)

(57) **Zusammenfassung**

Ein elektronisches Detektorsystem zur Erfassung von Röntgen- oder Korpuskularstrahlen ist durch folgenden Aufbau gekennzeichnet:
- ein planes isolierendes Trägermaterial (10),
- Grundelektroden in Form von auf dem isolierenden Trägermaterial (10) befindlichen äquidistanten Streifen (Yn) aus Metall mit einheitlichen Abmessungen,
- eine die Grundelektroden bedeckende planarisierende Isolierschicht aus amorphem Material (11),
- Deckelektroden (Xm) in Form von auf der Isolierschicht befindlichen äquidistanten Streifen aus Metall mit einheitlichen Abmessungen, die gegenüber den die Grundelektroden bildenden Metallstreifen um 90° gedreht sind, und
- eine zentrale Auswerteelektronik, mit der die einzelnen Elektroden verbunden sind,
wobei wenigstens eine der beiden Elektrodenarten aus einem Metall mit einer Ordnungszahl Z > 70 besteht.

## Beschreibung

Die Erfindung betrifft ein elektronisches Detektorsystem zur Erfassung von Röntgen- oder Korpuskularstrahlen.

Zur elektronischen Erfassung und Aufzeichnung von mit energiereicher Strahlung, wie Röntgen bzw. γ-Strahlen und Korpuskularstrahlen, gewonnenen Bildern, beispielsweise bei medizinischen oder biologischen Untersuchungen und bei Materialprüfungen, werden kleinflächige multiplexbare Sensor- bzw. Detektorelemente benötigt, die bei Bestrahlung elektrische Signale liefern. Die Sensorelemente sind - mit separaten Anschlüssen, über die ihre Signale von einer zentralen Auswerteelektronik digital abgerufen werden - in Form kleiner Strips oder Pixel in ein- oder zweidimensionalen Arrays angeordnet.

An derartige Sensorsysteme werden folgende Anforderungen gestellt:
- Hohe Signalempfindlichkeit der punktuellen Detektorelemente, um die Dosis der angewendeten Strahlung - vor allem in der Medizintechnik - auf ein physiologisch unschädliches Maß zu beschränken. Mit einem hohen und damit rauscharmen Detektorsignal können auch niedrigere Kosten bei der zentralen Auswerteelektronik erreicht werden (lineare Verstärkung).
- Kurze Ansprech- und Abklingzeit der Detektorelemente bei Änderung der Bestrahlung. Dies ist insbesondere bei sich bewegenden Bildern bzw. Objekten wichtig, damit die mit einer Frequenz von etwa 1 kHz abgerufenen Sensorelemente zeitlich nicht verwischte, sondern gut aufgelöste Signale liefern.
- Auslegung der Strips bzw. Pixel im µm-Bereich, um eine hohe örtliche Auflösung und eine hohe Konturenschärfe der Bilder zu erreichen.
- Stabile Meßsignale mit hoher Reproduzierbarkeit.
- Gleichmäßige Signalempfindlichkeit über das gesamte Detektorsystem.
- Keine Langzeitschädigung des Detektormaterials durch die Strahlungsexposition.

Als bildgebende Systeme, beispielsweise in der Röntgen-Computertomographie, gelangen derzeit insbesondere Festkörperszintillatoren mit Photosensoren und Germanium-PIN-Dioden zum Einsatz. Bei den Festkörperszintillatoren (mit Photosensoren) wird die Röntgenstrahlung zunächst in sichtbares Licht und erst dieses dann in elektrische Signale umgewandelt. Nachteilig ist hierbei, daß keine On-line-Signale erhalten werden, und daß ein Nachleuchten des Szintillationsmaterials bis zu einigen Millisekunden die zeitliche Bildauflösung begrenzt. Bei den Germanium-PIN-Dioden erfolgt die Umwandlung der Röntgenstrahlung in ein Elektron-Loch-Paar im Germaniumkristall. Hierbei erweist sich als nachteilig, daß - wegen eines zu hohen Dunkelstromes bei Raumtemperatur - eine Kühlung mit flüssigem Stickstoff erforderlich ist, und daß die Ortsauflösung - wegen der zur Vermeidung des Übersprechens notwendigen lateralen Unterteilung bzw. Trennung der Sensorelemente - gering ist.

Bei der elektronischen Erfassung von Röntgenbildern nach dem RBV-Prinzip (RBV = Röntgenbildschirmverstärker) wird durch die Röntgenstrahlen primär in einer CsJ-Schicht Licht erzeugt, durch das nachfolgend in einer Photokathode am Eingangsbildschirm einer Schwarz/Weiß-Bildröhre Elektronen freigesetzt werden; diese Elektronen werden dann auf den Austrittsbildschirm der Bildröhre elektronenoptisch fokussiert. Am Austrittsbildschirm befindet sich eine Schicht aus körnigem ZnCdS-Material, das durch die auftreffenden Elektronen zur Lichtemission angeregt wird (Wellenlänge: λ = 525 nm). Die damit erzeugten monochromatischen Bilder können dann beispielsweise mit Hilfe von Videoeinrichtungen erfaßt und gespeichert werden. Von Nachteil ist hierbei, daß die Lichtausbeute und die Bildauflösung wegen der Körnung des ZnCdS-Materials bzw. der damit verbundenen Streuverluste begrenzt ist. Eine Verbesserung mit Hilfe spiegelnder Aluminiumschichten ist jeweils nur bei einer dieser Größen möglich, und zwar auf Kosten der anderen.

Als Ersatz für photographische Röntgenfilme wurden bereits Kunststoffträgerfilme mit eingelagerten Speicherleuchtstoffpartikeln entwickelt. Dies sind Substanzen, wie BaFBr, mit sogenannten Farbzentren, in denen durch Bindung der durch die absorbierte Röntgenstrahlung freigesetzten Elektronen latente Röntgenbilder erzeugt werden (siehe dazu beispielsweise DE-OS 33 04 216 und DE-OS 33 47 207). Mit Hilfe von Laserlicht werden diese Farbzentren dann - unter Abspaltung der gespeicherten Elektronen - zur Emission von sichtbarem Licht angeregt, welches sich hinsichtlich der Intensität proportional zum gespeicherten Röntgenbild verhält. Im Gegensatz zum photographischen Film liefert dieses Verfahren eine lineare, d.h. gleichmäßige Signalempfindlichkeit. Von Nachteil ist aber, daß die Lichtausbeute pro Röntgenlichtquant begrenzt ist, keine Online-Signale möglich sind und die Abklingzeit wegen des optischen Auslesevorgangs nicht beliebig verkürzt werden kann.

Zur elektronischen Aufzeichnung von Röntgenbildern sind auch Detektoren in Form von Strips oder Pixel bekannt, die mit bis zu 40 µm dicken einlagigen a-Si- bzw. a-Si:H-Schichten hergestellt werden (siehe dazu: "IEEE Trans. Nucl. Sci.", Vol. 36 (1989), Seiten 1347 bis 1352, und "J. Non-Cryst. Solids", Vol. 115 (1989), Seiten 174 bis 176). Wegen der niedrigen Ordnungszahl von Silicium (Z = 14) ergibt sich hierbei aber eine geringe Signalempfindlichkeit. Dies bedeutet, daß bei kleinflächigen Strip- oder Pixel-Systemen für jedes Detektorelement eine individuelle Verstärkerschaltung benötigt wird, beispielsweise in Form von FETs aus a-Si:H.

Aus der EP-OS 0 239 808 ist eine Festkörper-Strahlungsdetektor-Vorrichtung bekannt, die zwei Metallschichten aus Metallen mit einer Ordnungszahl ("atomic number") von 30 oder mehr aufweist, welche eine Halbleiterschicht einschließen. Als Metalle sind Molybdän, Tantal und Gold genannt. Die Halbleiterschicht besteht im allgemeinen aus amorphem Silicium. Daneben sind als amorphe Halbleiter noch Germanium, Selen und Gallium aufgeführt. Beschrieben werden auch mehrlagige Pixelsysteme. Hierbei ist jedes Pixelelement an Adressenleitungen angeschlossen, was komplizierte Strukturierungsmaßnahmen erfordert.

Aufgabe der Erfindung ist es, ein Detektorsystem der eingangs genannten Art in der Weise auszugestalten, daß es das gesamte Anforderungsprofil, das an diese Systeme, insbesondere Röntgenbildsensoren, gestellt wird, erfüllt.

Dies wird erfindungsgemäß durch ein Detektorsystem erreicht, das durch folgenden Aufbau gekennzeichnet ist:
- ein planes isolierendes Trägermaterial,
- Grundelektroden in Form von auf dem isolierenden Trägermaterial befindlichen äquidistanten Streifen aus Metall mit einheitlichen Abmessungen,
- eine die Grundelektroden bedeckende planarisierende Isolierschicht aus amorphem Material,
- Deckelektroden in Form von auf der Isolierschicht befindlichen äquidistanten Streifen aus Metall mit einheitlichen Abmessungen, die gegenüber den die Grundelektroden bildenden Metallstreifen um 90° gedreht sind, und
- eine zentrale Auswerteelektronik, mit der die einzelnen Elektroden verbunden sind,
wobei wenigstens eine der beiden Elektrodenarten aus einem Metall mit einer Ordnungszahl Z > 70 besteht.

Mit dem Detektorsystem nach der Erfindung lassen sich die an Röntgenbildsensoren zu stellenden Forderungen sehr gut erfüllen. Ein grundsätzlicher Vorteil dieses Detektorsystems besteht darin, daß eventuell vorhandene bzw. auftretende Isolationsfehlstellen allenfalls nur zum Ausfall des betreffenden Pixels, nicht aber zum Versagen des gesamten Systems führen können.

Beim erfindungsgemäßen Detektorsystem besteht die planarisierende Isolierschicht im allgemeinen aus einem Isolierlack, aus einem Plasmapolymerisat oder aus amorphem wasserstoffhaltigem Kohlenstoff (a-C:H). Geeignete Isolierlacke sind beispielsweise Polyimidlacke. Als Plasmapolymerisate kommen insbesondere Dünnschichten auf der Basis von Kohlenwasserstoffen, Fluorkohlenwasserstoffen und Fluorkohlenstoffen in Betracht.

Bevorzugt wird eine Isolierschicht aus a-C:H. Amorpher wasserstoffhaltiger Kohlenstoff ist eine neuartige röntgenamorphe Kohlenstoffmodifikation, in der die C-Atome teils tetraedrisch (sp³), teils trigonal (sp²) - unter Einbindung eines unterstöchiometrischen H-Anteils - hybridisiert sind (siehe beispielsweise: "IDR - Industrie Diamanten Rundschau", Bd. 18 (1984), Seiten 249 bis 253). Dieses Material hat eine bemerkenswert hohe mechanische und chemische Stabilität und es stellt zudem eine ausgezeichnete Feuchtebarriere dar (siehe dazu: Herbert Reichl (Editor) "Micro System Technologies 90", Springer-Verlag Berlin Heidelberg 1990, Seiten 307 bis 312).

Für das erfindungsgemäße Detektorsystem besteht ein besonderer Vorteil darin, daß Schichten aus a-C:H elektrisch isolierend sind, a-C:H aber trotzdem eine ausreichende elektronische Leitfähigkeit besitzt. Darüber hinaus können die intrinsischen optischen und elektrischen Eigenschaften (optischer Bandabstand, Dielektrizitätszahl und Isolationswiderstand) von a-C:H - durch die Bedingungen bei der Herstellung, die durch Plasmaabscheidung erfolgt - in einem weiten Bereich gesteuert und speziellen Anforderungen angepaßt werden. Bemerkenswert ist auch ein ausgeprägter Avalanche-Effekt, indem die aus Metallelektroden in a-C:H übertretenden bzw. injizierten Elektronen durch anliegende hohe elektrische Felder soweit energetisch beschleunigt werden können, daß durch Elektronenlawinenbildung eine hohe Meßstromverstärkung erfolgt. Dieser Effekt tritt in a-C:H bei Feldstärken um 10⁵ V/cm auf. Im Gegensatz dazu zeigt sich bei a-Si:H bei Feldstärken bis zu 2.10⁵ V/cm noch kein Avalanche-Effekt.

Ein zur elektrischen Erfassung von Röntgen- bzw. γ- und Korpuskularstrahlen geeigneter Detektor in Dünnschichttechnik, der eine zwischen zwei Metallelektroden, von denen wenigstens eine aus einem Metall mit einer Ordnungszahl Z > 70 besteht, angeordnete Isolierschicht aus plasmaabgeschiedenem a-C:H aufweist, ist Gegenstand der gleichzeitig eingereichten europäischen Patentanmeldung Nr. - GR 91 P 3377 E ("Strahlungsdetektor"). Bei diesem Detektor ist wesentlich, daß der amorphe wasserstoffhaltige Kohlenstoff einen optischen Bandabstand ≧ 0,9 eV aufweist, und daß die a-C:H-Schicht, die als Ladungstransportschicht dient, zu der aus einem Metall mit Z > 70 bestehenden Elektrode eine defektarme Grenzschicht mit ohmschen Kontakten bildet. Das Detektorsystem nach der vorliegenden Erfindung weist vorteilhaft eine entsprechende a-C:H-Isolierschicht auf. Die Dicke der Isolierschicht beträgt vorzugsweise 0,3 bis 5 µm.

Eine oder beide Elektrodenarten des erfindungsgemäßen Detektorsystems bestehen aus einem Metall mit einer Ordnungszahl Z > 70. Im allgemeinen dient dazu ein Schwermetall in Form von Tantal (Z = 73), Wolfram (Z = 74), Rhenium (Z = 75), Osmium (Z = 76), Iridium (Z = 77), Platin (Z = 78) oder Gold (Z = 79). Vorzugsweise besteht eine der beiden Elektrodenarten aus einem der genannten Schwermetalle und die andere Elektrodenart aus Aluminium (Z = 13). Neben Aluminium kommen für diese Elektrodenart beispielsweise auch Nickel (Z = 28) und Kupfer (Z = 29) in Betracht. Die Schwermetallelektroden weisen vorzugsweise eine Dicke von 1 bis 5 µm auf; diese Elektroden können prinzipiell aber auch in Form von Metallfolien vorliegen. Die Elektroden aus Aluminium usw. besitzen im allgemeinen eine Dicke ≦ 1 µm. Das Trägermaterial, auf dem die metallischen Grundelektroden angeordnet sind, ist insbesondere ein Wafer, ein Glassubstrat, beispielsweise aus Quarzglas, oder eine Folie aus Kunststoff.

Das erfindungsgemäße Detektorsystem kann vorteilhaft in Mehrlagentechnik aufgebaut sein. In diesem Fall sind dann auf dem isolierenden Trägermaterial wenigstens zwei Detektormodule aus Grundelektroden, planarisierender Isolierschicht und Deckelektroden deckungsgleich übereinander angeordnet, wobei die einzelnen Module jeweils durch eine planarisierende Zwischenschicht aus isolierendem Material voneinander getrennt sind. Die planarisierende Zwischenschicht besteht dabei vorzugsweise aus a-C:H, sie kann beispielsweise aber auch ein Isolierlack sein.

Beim Mehrlagenaufbau sind die übereinanderliegenden Grund- bzw. Deckelektroden jeweils am Rand leitend miteinander verbunden. Die elektronische Ansteuerung der einzelnen Pixelelemente mit dem Ziel, Informationen, die darin beispielsweise elektrostatisch gespeichert sind, abzurufen und zentral zu verarbeiten, erfolgt nach an sich bekannten Methoden. Hierzu sei beispielhaft auf die Festkörperstrahlungsdetektor-Vorrichtung nach der EP-PS 0 239 808 verwiesen.

Die Röntgenbildsensor-Arrays nach der Erfindung weichen im Aufbau in technologischer Hinsicht im übrigen grundlegend von der bekannten Vorrichtung ab und bieten in bezug auf die technische Machbarkeit signifikante Vorteile. Wahrend nämlich bei der bekannten Vorrichtung jedes Pixelelement an Adressenleitungen angeschlossen ist, dienen beim erfindungsgemäßen Detektorsystem die Enden der die einzelnen Pixelelemente bildenden Elektrodenbahnen, die senkrecht zueinander verlaufen, zugleich die Kontaktanschlüsse, was in bezug auf die Kontaktierung der Einzelelemente eine technisch einfache Lösung darstellt.

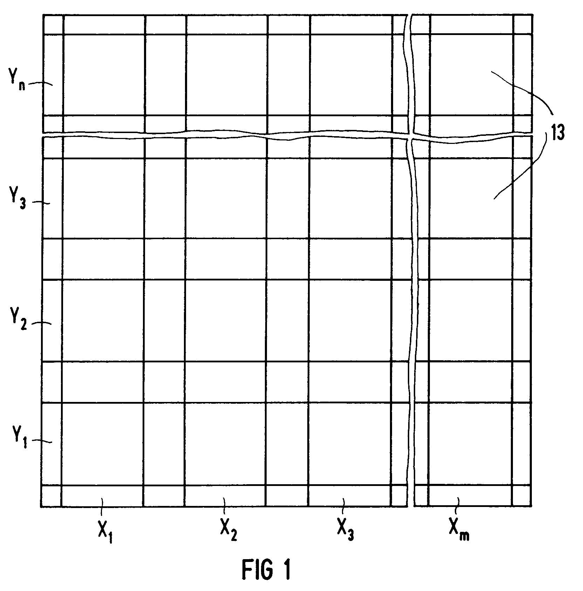

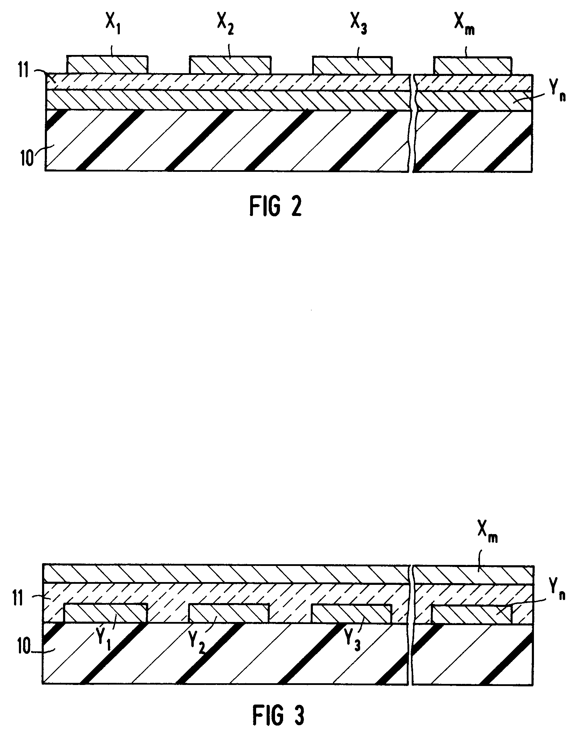

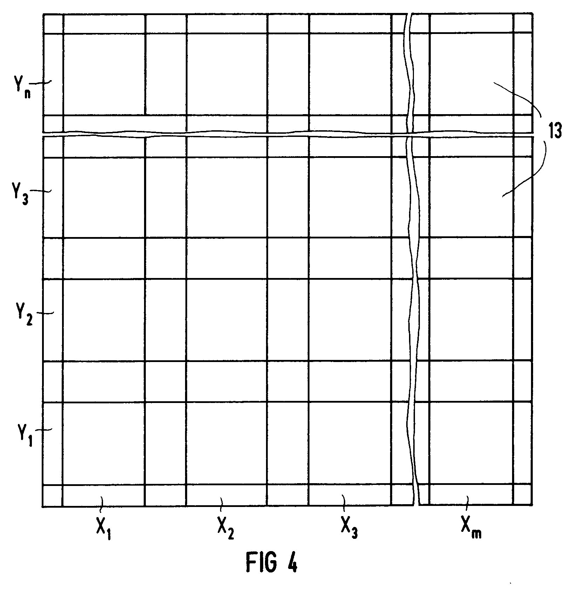

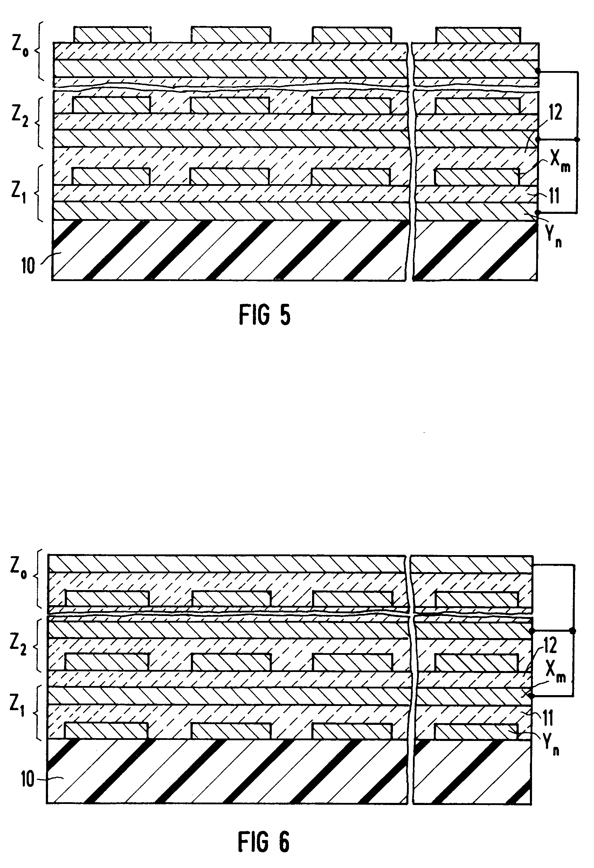

Anhand von Ausführungsbeispielen und Figuren soll die Erfindung noch näher erläutert werden. In den Figuren 1 bis 3 ist dabei ein einfach aufgebautes Detektorsystem nach der Erfindung dargestellt, in den Figuren 4 bis 6 ein Mehrlagensystem, wobei die Detektorsysteme jeweils in Draufsicht (Fig. 1 bzw. Fig. 4) und in zwei Seitenansichten (Fig. 2 und 3 bzw. Fig. 5 und 6) wiedergegeben sind.

Auf ein isolierendes Trägermaterial 10, das fest (Wafer bzw. Glassubstrat) oder flexibel (Kunststoffolie) sein kann, wird in Form äquidistanter Streifen Y₁, Y₂, Y₃ ... Yₙ eine Schicht aus einem Schwermetall, d.h. Ta, W, Re, Os, Ir, Pt oder Au, aufgebracht, insbesondere durch Sputtern oder Aufdampfen. Die Streifenstruktur kann entweder mit Hilfe von Streifenmasken bei der Abscheidung oder aus einer ganzflächigen Metallschicht durch nachfolgendes Photoätzen erzeugt werden. Auf die Metallstreifen bzw. -bahnen, welche die sogenannten Grundelektroden darstellen, wird dann ganzflächig eine planarisierende Isolierschicht 11 aus amorphem Material, wie a-C:H, aufgebracht; diese Schicht füllt auch den Raum zwischen den Grundelektroden weitgehend aus. Auf die Isolierschicht 11 wird nachfolgend - in entsprechender Weise wie bei den Grundelektroden - eine metallische Streifenstruktur aufgebracht, wobei die Metallstreifen bzw. -bahnen X₁, X₂, X₃ ... Xₘ, welche die sogenannten Deckelektroden darstellen, in einer planparallelen Ebene senkrecht zu den Grundelektroden verlaufen. Als Material für die Deckelektroden kann eines der vorstehend genannten Schwermetalle oder Aluminium dienen.

Die beiden Metallbahnsysteme (X₁ ... Xₘ und Y₁ ... Yₙ) bilden in ihren Überkreuzungsflächen mit der dazwischenliegenden Isolierschicht Pixelelemente 13 für Detektoren für γ- bzw. Röntgen- und für Korpuskularstrahlen. Zugleich bilden die Metallbahnsysteme für alle diese Elemente die Kontaktanschlüsse, die - voneinander isoliert - am Rand mit einer zentralen Auswerteelektronik verbunden werden, welche die Pixelelemente digital abruft.

Neben einem auf die vorstehend beschriebene Weise erhaltenen zweidimensionalen Array einlagiger Detektorelemente entsprechend Fig. 1 bis 3 können - durch deckungsgleiche Aufeinanderstapelung von Schicht- bzw. Metallstreifenanordnungen - auch entsprechende Arrays mit mehrlagigen, elektrisch voneinander getrennten Detektorelementen erhalten werden, wobei die übereinanderliegenden gleichen Metallbahnen jeweils am Rand leitend miteinander verbunden sind (siehe Fig. 4 bis 6). Die einzelnen Detektormodule Z₁, Z₂ ... Zₒ sind dabei durch eine planarisierende Zwischenschicht 12 aus isolierendem Material voneinander getrennt.

Aufgrund der relativ einfachen Technologie und wegen der Verwendung amorpher Isolierschichten mit hoher Homogenität erlaubt ein Aufbau der vorstehend beschriebenen Art die Realisierung sehr kleiner Pixelflächen, wobei die damit verbundene Signalstromminderung der Pixel durch einen Mehrlagenaufbau kompensiert werden kann. Als Material für die Isolierschichten kommt dabei insbesondere amorpher wasserstoffhaltiger Kohlenstoff in Betracht, der - bei Wahl spezieller Abscheideparameter - in besonderem Maße über die Eigenschaft eines hohen Planarisierungsgrades verfügt, speziell bei Feinstrukturen (siehe dazu: "IEEE Electron Device Letters", Vol. 11 (1990), Seiten 391 bis 393). Mit a-C:H (Schichtdicke: 3 µm) läßt sich - in Verbindung mit einer etwa 3 µm dicken Wolframelektrode und einer 0,1 µm dicken Gegenelektrode aus Aluminium - für 50 kV-Röntgenstrahlen bei einer Dosisleistung von 0,2 R/s, bei biasfreier Messung, eine Signalempfindlichkeit von ≧ 1,6 nA/cm² erreichen, was die Werte von Dünnschichtdetektoren auf der Basis von a-Si:H deutlich übertrifft. Dieses Signal kann durch Anwendung des Mehrlagenprinzips um einen Faktor bis zu 35 und durch Anlegen einer Meßspannung - unter Ausnutzung eines Avalanche-Effektes - noch weiter um einen Faktor > 15 gesteigert werden, so daß ein Meßstrom von > 8.10⁻⁷ A/cm² - mit einer 50 kV-Röntgenstrahlung bei einer Dosisleistung von 0,2 R/s - ermöglicht wird. Von Vorteil bei a-C:H ist ferner, daß - aufgrund der zu hohen Werten hin steuerbaren elektronischen Leitfähigkeit - die aus den Wolframelektroden emittierten Elektronen bei Abbruch der Röntgenstrahlenexposition sehr rasch abfließen, womit sehr kurze Abklingzeiten der Detektorelemente erreicht werden können.

Zur Herstellung eines Detektorsystems nach der Erfindung werden - mit Hilfe einer mechanischen Maske - auf einen oxidierten Siliciumwafer, der eine sehr glatte und isolierende Oberfläche aufweist, 0,5 mm breite Streifen aus Wolfram mit einer Dicke von 1,5 µm im Abstand von 0,5 mm aufgebracht. Darauf wird dann eine 3 µm dicke Schicht aus a-C:H abgeschieden, welche die Metallbahnen um 1,5 µm überdeckt und die Gräben zwischen den Bahnen bis zu 85 % planarisierend ausfüllt.

Die Herstellung der a-C:H-Schicht erfolgt durch Plasmaabscheidung mittels RF-Anregung (Frequenz: beispielsweise 13,56 MHz), wobei sich aufgrund ungleicher Elektroden (Flächenverhältnis ≧ 2) eine DC-Self-bias-Spannung einstellt. Zur Ausbildung einer defektarmen Carbid-Grenzschicht (Dicke ≦ 50 nm) mit einem optischen Bandabstand ≧ 0,9 eV wird dabei zunächst ein Druck von ca. 20 Pa (Reaktionsgas: CH₄) eingestellt und mit einer HF-Leistungsdichte von 2,5 W/cm² (auf der Kathode) eine DC-Self-bias-Spannung von -900 V erzeugt. Nachfolgend wird dann, ohne Zwischenbelüftung, bei einer HF-Leistungsdichte von 0,5 W/cm² (auf der Kathode) bei einem Druck des Reaktionsgases von ca. 200 Pa und einer DC-Self-bias-Spannung von -150 V innerhalb von ca. 18 min eine 3 µm dicke a-C:H-Schicht abgeschieden. Diese a-C:H-Schicht weist einen optischen Bandabstand von ca. 2 ev und einen spezifischen elektrischen Widerstand von ca. 10¹⁷ Ω.cm auf.

Nach der a-C:H-Abscheidung werden auf die a-C:H-Schicht quer zu den Wolframstreifen liegende, gleich dimensionierte Streifen aus Aluminium aufgebracht. Auf diese Weise wird ein Detektorsystem entsprechend Fig. 1 bis 3 erhalten, das - bei biasfreier Messung - eine Signalempfindlichkeit von ca. 1,7 nA/cm² besitzt.

## Patentansprüche

1. Elektronisches Detektorsystem zur Erfassung von Röntgen- oder Korpuskularstrahlen, **gekennzeichnet**
durch folgenden Aufbau:
- ein planes isolierendes Trägermaterial,
- Grundelektroden in Form von auf dem isolierenden Trägermaterial befindlichen äquidistanten Streifen aus Metall mit einheitlichen Abmessungen,
- eine die Grundelektroden bedeckende planarisierende Isolierschicht aus amorphem Material,
- Deckelektroden in Form von auf der Isolierschicht befindlichen äquidistanten Streifen aus Metall mit einheitlichen Abmessungen, die gegenüber den die Grundelektroden bildenden Metallstreifen um 90° gedreht sind, und
- eine zentrale Auswerteelektronik, mit der die einzelnen Elektroden verbunden sind,
wobei wenigstens eine der beiden Elektrodenarten aus einem Metall mit einer Ordnungszahl Z > 70 besteht.

2. Detektorsystem nach Anspruch 1, **dadurch gekennzeichnet,** daß die planarisierende Isolierschicht aus einem Isolierlack, aus einem Plasmapolymerisat oder aus amorphem wasserstoffhaltigem Kohlenstoff (a-C:H) besteht.

3. Detektorsystem nach Anspruch 2, **dadurch gekennzeichnet,** daß die Isolierschicht aus a-C:H mit einem optischen Bandabstand ≧ 0,9 eV besteht und zu den Elektroden aus einem Metall mit einer Ordnungszahl Z > 70 defektarme Grenzschichten mit ohmschen Kontakten bildet.

4. Detektorsystem nach einem der Ansprüche 1 bis 3, **dadurch gekennzeichnet,** daß die Dicke der Isolierschicht 0,3 bis 5 µm beträgt.

5. Detektorsystem nach einem oder mehreren der Ansprüche 1 bis 4, **dadurch gekennzeichnet,** daß wenigstens eine der beiden Elektrodenarten aus einem Schwermetall in Form von Tantal, Wolfram, Rhenium, Osmium, Iridium, Platin oder Gold besteht.

6. Detektorsystem nach Anspruch 5, **dadurch gekennzeichnet,** daß eine der beiden Elektrodenarten aus einem Schwermetall und die andere aus Aluminium besteht.

7. Detektorsystem nach Anspruch 5 oder 6, **dadurch gekennzeichnet,** daß die Schwermetallelektroden eine Dicke von 1 bis 5 µm aufweisen.

8. Detektorsystem nach einem oder mehreren der Ansprüche 1 bis 7, **dadurch gekennzeichnet,** daß das isolierende Trägermaterial ein Wafer, ein Glassubstrat oder eine Kunststoffolie ist.

9. Detektorsystem nach einem oder mehreren der Ansprüche 1 bis 8, **dadurch gekennzeichnet,** daß auf dem Trägermaterial wenigstens zwei Detektormodule aus Grundelektroden, planarisierender Isolierschicht und Deckelektroden deckungsgleich übereinander angeordnet sind, daß die einzelnen Detektormodule jeweils durch eine planarisierende Zwischenschicht aus isolierendem Material voneinander getrennt sind, und daß die übereinanderliegenden Grund- bzw. Deckelektroden jeweils am Rand leitend miteinander verbunden sind.

10. Detektorsystem nach Anspruch 9, **dadurch gekennzeichnet,** daß die planarisierende Zwischenschicht aus amorphem wasserstoffhaltigem Kohlenstoff besteht.
